# EUROPÄISCHE PATENTSCHRIFT

(11) **EP 0 649 565 B1**
(45) Veröffentlichungstag und Bekanntmachung des Hinweises auf die Patenterteilung: **30.09.1998**
(21) Anmeldenummer: 93912615.7
(22) Anmeldetag: 24.06.1993
(51) Int. Cl.: H01L 25/16, H01L 23/14, H01L 23/373

(54) **MONTAGEEINHEIT FÜR MEHRLAGENHYBRID MIT LEISTUNGSBAUELEMENTEN**
FITTING UNIT FOR MULTILAYER HYBRID CIRCUIT WITH POWER COMPONENTS
UNITE DE MONTAGE POUR CIRCUIT HYBRIDE MULTICOUCHE MUNI DE COMPOSANTS DE PUISSANCE

(30) Priorität: 09.07.1992 DE 4222474
(43) Veröffentlichungstag der Anmeldung: 26.04.1995
(73) Patentinhaber: ROBERT BOSCH GMBH, 70442 Stuttgart (DE)
(72) Erfinder: ROETHLINGSHOEFER, Walter, D-72766 Reutlingen (DE); GOEBELS, Ulrich, D-72760 Reutlingen (DE)
(86) Internationale Anmeldenummer: DE9300548
(87) Internationale Veröffentlichungsnummer: WO9401889

(56) Entgegenhaltungen:
- EP-A- 434 264
- WO-A-89/00339
- WO-A-92/06496
- US-A- 4 563 383
- US-A- 4 862 323

## Beschreibung

### Stand der Technik

Die Erfindung geht aus von einer Montageeinheit für einen Mehrlagenhybrid nach der Gattung des Hauptanspruchs. Es sind bereits Mehrlagenhybride mit Leistungsbauelementen aus der DE-OS 40 31 733 bekannt. Hier werden Mehrlagenhybride mit Leistungsbauelementen speziell IC's verwendet, wobei die Leistungsbauelemente beispielsweise auf der Oberseite des Hybrids aufmontiert werden und deren Verlustwärme über zum Teil aufwendige Konstruktionen mittels Kühlblech, Kühlkörper oder Kühlfedern abgeleitet wird. Weiterhin ist daraus bekannt, Leistungs-IC's in Vertiefungen auf der Rückseite des Mehrlagenhybrids beispielsweise so einzubringen, daß der Mehrlagenhybrid mit seiner Rückseite ganzflächig auf einer Trägerplatte aufgebracht werden kann. Hierbei kann an den Stellen, an denen ein Leistungsbauelement rückseitig angebracht ist, ein Wärmestau entstehen, da durch die Trägerplatte die entstehende Wärme nicht optimal abgeleitet wird.

Es ist die Aufgabe der Erfindung, die Leistungsbauelemente auf einem Mehrlagenhybrid so an die Trägerplatte anzuordnen, daß eine sehr gute Wärmeabgabe erfolgt.

### Vorteile der Erfindung

Die Anordnung gemäß Ansprüche 1 und 2, und mit den kennzeichnenden Merkmalen der nebengeordneten Ansprüche hat den Vorteil, daß eine direkte Wärmeableitung über die Trägerplatte beispielsweise an eine Gehäusegrundplatte ermöglicht wird. Als weiterer Vorteil ist anzusehen, daß durch die Montage der Leistungsbauelemente auf die Rückseite keine metallgefüllten Kanäle (stacked Vias) benötigt werden, wodurch in mehreren Leiterbahnebenen des Multilayerhybrids mehr Verdrahtungsfläche zur Verfügung steht.

Die Anordnung mit den Merkmalen des ersten nebengeordneten Anspruch, wonach eine beidseitig mit Kupfer beschichtete Keramikplatte zu verwenden ist, mit Aussparungen zu versehen ist, so daß die Kupferfolie über diesen Aussparungen gespannt ist und erst bei der Montage des Hybrids in die entsprechenden Vertiefungen gedrückt wird, hat den Vorteil, daß eine exakte Anpassung an die unterschiedlichen Chipdicken möglich.

Die Anordnung mit den Merkmalen des zweiten nebengeordneten Anspruchs betrifft den Aufbau der Trägerplattemit mit der Schichtfolge Keramik-Kupferfolie-Keramik. Hier können vorteilhaft die Vertiefungen für IC's bzw. für Anschlußverbindungen zum Mehrlagenhybrid durch entsprechende Aussparungen in der Keramik gestaltet werden.

Durch die in den Unteransprüchen aufgeführten Maßnahmen sind vorteilhafte Weiterbildungen und Verbesserungen des angegebenen Merhlagenhybrids möglich. Es ist vorteilhaft, daß die Kupferfolie am Rande der Trägerplatte als überstehender Anschlußkamm ausbildbar ist, wodurch dieser einerseits über Bondverbindungen mit dem Hybrid und andererseits mit einem Gehäusestecker verbunden werden kann. Letztendlich ist es möglich die Kupferfolie auf dem Keramikträger entsprechend zu strukturieren, so daß Verbindungen von verschiedenen Stellen des Merhlagenhybrids weg bzw. zuführbar sind. Hierbei ist es besonders vorteilhaft, daß die Verbindungen entsprechend niederohmig ausgebildet werden können.

### Zeichnung

Ausführungsbeispiele der Erfindung sind in der Zeichnung dargestellt und in der nachfolgenden Beschreibung näher erläutert. Es zeigt Figur 1 die Trägerplatte mit Kupfer/Keramik/Kupfer-Schichtfolge Figur 2 die Trägerplatte mit montiertem Mehrlagenhybrid und Figur 3 eine montierte Trägerplatte mit Keramik/Kupfer/Keramik-Schichtfolge.

### Beschreibung der Ausführungsbeispiele

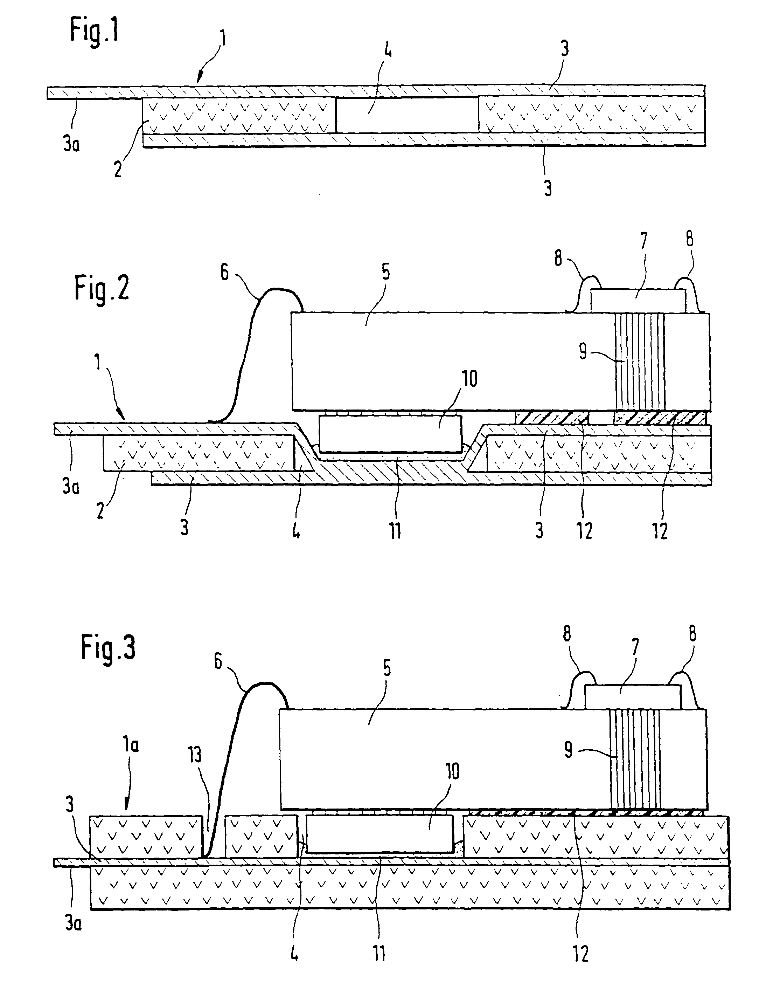

Die Figur 1 zeigt die Trägerplatte 1, auf welcher ein Mehrlagenhybrid aufmontiert wird. Diese Trägerplatte 1 besteht aus einer Keramikplatte 2, die ca. 0,3 bis 2 mm dick ist. Diese Keramikplatte 2 ist beidseitig mit je einer Kupferfolie 3 beschichtet. Die Keramikplatte 2 kann Aussparungen 4 aufweisen, die dann von den Kupferfolien 3 überspannt werden.

Figur 2 zeigt die Trägerplatte 1 mit aufmontiertem Mehrlagenhybrid 5. Ein solcher Mehrlagenhybrid 5 besteht üblicherweise aus Keramik, wobei verschiedene Bauteile, wie zum Beispiel Widerstände und Kondensatoren in verschiedene Schichten eingebracht sind. Die Anschlüsse des Mehrlagenhybrids 5 sind über Drähte 6 mit nicht dargestellten Außenanschlüssen außerhalb des Mehrlagenhybrids oder mit entsprechenden Leiterbahnen der strukturierten Kupferfolie 2 verbunden. Am Mehrlagenhybrid 5 sind zwei Leistungs-Halbleiterbauelemente in IC-Ausführung auf verschiedene Weise befestigt. So ist ein Leistungs-IC 7 auf die Oberseite des Mehrlagenhybrids aufgebracht und mittels Bonddrähten 8 mit Leiterbahnen an der Oberseite des Mehrlagenhybrids 5 kontaktiert. Zu deren Wärmeableitung an die Trägerplatte 1 werden in den Mehrlagenhybrid mehrere Kanäle, sogenannte stacked vias 9 eingebracht, die durch den gesamten Mehrlagenhybrid 5 hindurch von dem Leistungs-IC 7 bis zur Trägerplatte 1 führen. Die hierbei relativ schlechte Wärmeableitung an die Trägerplatte wird gemäß dem Stand der Technik durch die Montage von Leistungs-IC's 10 auf die Rückseite des Mehrlagenhybrids 5 je nach Anforderung verbessert. Diese Leistungs-IC 10 können mit dem an sich bekannten Verfahren Flip-Chip-Löten (US-PS 3 517 279) am Mehrlagenhybrid 5 kontaktiert werden. Bei der Montage des Mehrlagenhybrids 5 auf die Trägerplatte 1 werden nun erfindungsgemäß die auf der Rückseite des Mehrlagenhybrids 5 montierten Leistungs-IC's 10 so über die Aussparungen 4 der Keramikplatte 2 gebracht, daß sie die Kupferfolie 3 in die Aussparung 4 hineindrücken, so daß eine Vertiefung entsteht, die genau der Chipdicke des Leistungs-IC's 10 entspricht. Alternativ können die Vertiefungen mit entsprechenden Werkzeugen vorgeprägt werden. Die Leistungs-IC's 10 sind über eine Wärmeleitpaste 11 an die Kupferfolie 3 gekoppelt. Der Mehrlagenhybrid 5 ist mit einem wärmeleitfähigem Kleber 12 an der Trägerplatte 1 befestigt. Damit sind keine zusätzlichen Konstruktionen zum Ableiten der Wärme vom Leistungs-IC 10 notwendig. Die am Leistungs-IC 10 entstehende Wärme kann so direkt an die ihn umgebende Trägerplatte 1 weitergegeben und von dort an die Gehäusegrundplatte eines Schaltgerätes oder dergleichen weggeleitet werden.

Weiterhin ist es möglich, die überstehende Kupferfolie 3 als Anschlußkamm 3a auszubilden, so daß eine einfache Kontaktierung an die Außenanschlüsse ohne zusätzliche Bonddrähte möglich ist.

Figur 3 zeigt den Mehrlagenhybrid 5 auf einer Trägerplatte la mit Keramik-Kupfer-Keramik-Schichtfolge, d.h. eine Kupferfolie 3 ist beidseitig mit Keramik 2 beschichtet, wobei die Keramikdicke jeweils entsprechend der IC-Dicke festgelegt wird. Der IC 10 ist hierbei ebenfalls über eine Wärmeleitpaste 11 an die Kupferfolie 3 angekoppelt, während der Mehrlagenhybrid 5 mit wärmeleitfähigem Kleber 12 auf die Trägerplatte geklebt ist. Die Kontaktierung des Mehrlagenhybrids erfolgt über die Bonddrähte 6 und entsprechende Kontakt-Aussparungen 13 an die Kupferfolie 3. Ebenso ist es aber auch möglich den Bonddraht 6 an einen externen Kontakt z.B. einen Stecker zu führen.

Der Kleber zum Befestiggen des Mehrlagenhybrids kann auf die Trägerplatte 1; la flächig aufgebracht werden, so daß - gemäß Figur 3 - eine der Größe des Mehrlagenhybrids entsprechende Klebefläche entsteht. Denkbar sind aber auch gemäß Figur 2 lokal verteilte Klebepunkte.

## Patentansprüche

1. Montageeinheit für Mehrlagenhybrid mit Halbleiter-Leistungsbauelementen in IC-Ausführungen, welcher auf einer Trägerplatte befestigt ist, dadurch gekennzeichnet, daß die Trägerplatte (1) eine beidseitig mit Kupferfolie (3) beschichtete Keramikplatte (2) ist und Aussparungen (4) aufweist, die mit Kupferfolie (3) überspannt sind, wobei die Kupferfolie (3) nach der Montage durch die auf der Rückseite des Mehrlagenhybrids (5) befestigten Leistungs-Halbleiterbauelemente (10) in die Aussparungen gedrückt ist, so daß die Kupferfolie (3) sich der Chipdicke des Leistungs-Halbleiterbauelementes (10) anpaßt.

2. Montageeinheit für Mehrlagenhybride mit Halbleiter-Leistungsbauelementen in IC-Ausführungen, welcher auf einer Trägerplatte befestigt ist, dadurch gekennzeichnet, daß die Trägerplatte (la) eine beidseitig mit Keramik beschichtete Kupferfolie (3) ist und Aussparungen aufweist, in die die auf der Rückseite des Mehrlagenhybrids befestigten Halbleiter-Leistungsbauelemente (10) eingesetzt und über Bonddrähte (6) mit der Kupferfolie (3) kontaktiert sind.

3. Montageeinheit nach Anspruch 1 und 2, dadurch gekennzeichnet, daß der Mehrlagenhybrid mit seinen auf der der Trägerplatte zugewandten Seite angeordneten Halbleiter-Leistungsbauelementen (10) auf die Trägerplatte (1) geklebt ist.

4. Montageeinheit nach Anspruch 1 und 2, dadurch gekennzeichnet, daß der Mehrlagenhybrid (5) mit seinen auf der der Trägerplatte zugewandten Seite angeordneten Halbleiter-Leistungsbauelementen (10) mittels Wärmeleitpaste (11) an die Trägerplatte (1) angekoppelt ist.

5. Montageeinheit nach Anspruch 1, dadurch gekennzeichnet, daß die Keramikplatte (2) ca. 0,3 bis 2 mm dick ist.

6. Montageeinheit nach einem der vorhergehenden Ansprüche, dadurch gekennzeichnet, daß die Kupferfolie (3) eine Leiterbahnstrukturierung aufweist.

7. Montageeinheit nach einem der vorhergehenden Ansprüche, dadurch gekennzeichnet, daß die Kupferfolie (3) als Kammanschluß (3a) nach außen geführt ist.

## Claims

1. Mounting unit for multilayer hybrid circuit with semiconductor power components in IC designs, which multilayer hybrid circuit is fastened on a carrier plate, characterized in that the carrier plate (1) is a ceramic plate (2) coated with copper foil (3) on both sides and has cutouts (4) which are straddled by copper foil (3), after mounting the copper foil (3) being pressed into the cutouts by the power semiconductor components (10) fastened on the rear side of the multilayer hybrid circuit (5), with the result that the copper foil (3) is matched to the chip thickness of the power semiconductor component (10).

2. Mounting unit for multilayer hybrid circuit with semiconductor power components in IC designs, which multilayer hybrid circuit is fastened on a carrier plate, characterized in that the carrier plate (la) is a copper foil (3) coated with ceramic on both sides and has cutouts into which the semiconductor power components (10) fastened on the rear side of the multilayer hybrid circuit are inserted and are contact-connected to the copper foil (3) via bonding wires (6).

3. Mounting unit according to Claims 1 and 2, characterized in that the multilayer hybrid circuit is bonded onto the carrier plate (1) by its semiconductor power components (10) arranged on the side facing the carrier plate.

4. Mounting unit according to Claims 1 and 2, characterized in that the multilayer hybrid circuit (5) is coupled by means of thermally conductive paste (11) to the carrier plate (1) by its semiconductor power components (10) arranged on the side facing the carrier plate.

5. Mounting unit according to Claim 1, characterized in that the ceramic plate (2) has a thickness of approximately 0.3 to 2 mm.

6. Mounting unit according to one of the preceding claims, characterized in that the copper foil (3) has conductor track structuring.

7. Mounting unit according to one of the preceding claims, characterized in that the copper foil (3) is routed to the outside as a comb terminal (3a).

## Revendications

1. Unité de montage pour un circuit hybride multicouche comportant des composants semi-conducteurs de puissance réalisés sous la forme de circuits intégrés, le circuit multicouche étant fixé sur une plaque de support,
caractérisée en ce que
- la plaque de support (1) est une plaque en céramique (2) revêtue sur ses deux faces d'une feuille de cuivre (3) et comportant des cavités (4) sur lesquelles est tendue la feuille de cuivre (3),
- la feuille de cuivre (3) est enfoncée dans les cavités après montage, par les composants semi-conducteurs de puissance (10) fixés sur la face arrière du circuit hybride multicouche (5), pour que la feuille de cuivre (3) s'adapte à l'épaisseur de la puce constituant le composant semi-conducteur de puissance (10).

2. Unité de montage pour circuit hybride multicouche comprenant des composants semi-conducteurs de puissance sous forme de circuits intégrés, ce circuit hybride étant fixé sur une plaque de support,
caractérisée en ce que
la plaque de support (la) est une feuille de cuivre (3) dont les deux faces, revêtues de matière céramique, comportent des cavités dans lesquelles sont placés les composants semi-conducteurs de puissance (10) de la face arrière du circuit hybride multicouche, qui sont mis en contact avec la feuille de cuivre (3) par des fils de liaison (6).

3. Unité de montage selon la revendication 1 ou 2,
caractérisée en ce que
le circuit hybride multicouche est collé sur la plaque de support (1) avec ses composants semi-conducteurs de puissance (10) prévus sur la face tournée vers la plaque de support.

4. Unité de montage selon l'une quelconque des revendications 1 et 2,
caractérisée en ce que
le circuit hybride multicouche (5) est couplé avec ses composants semi-conducteurs de puissance (10) prévus sur sa face tournée vers la plaque de support, contre la plaque de support (1), par l'intermédiaire d'une patte conductrice de chaleur (11).

5. Unité de montage selon la revendication 1,
caractérisée en ce que
la plaque en céramique (2) a une épaisseur comprise entre environ 0,3 et 2 mm.

6. Unité de montage selon l'une quelconque des revendications précédentes,
caractérisée en ce que
la feuille de cuivre (3) présente une structure de chemins conducteurs.

7. Unité de montage selon l'une quelconque des revendications précédentes,
caractérisée en ce que
la feuille de cuivre (3) est conduite à l'extérieur sous la forme d'un branchement en peigne (3a).
